# EUROPÄISCHE PATENTSCHRIFT

(11) **EP 1 422 192 B1**
(45) Veröffentlichungstag und Bekanntmachung des Hinweises auf die Patenterteilung: **18.04.2007**
(21) Anmeldenummer: 02079899.7
(22) Anmeldetag: 25.11.2002
(51) Int. Cl.: B81C 1/00, B29C 45/03, B29C 33/38, B29C 33/42, B23P 15/00

(54) **Verfahren zur Herstellung eines Werkzeugeinsatzes zum Spritzgiessen eines teils mit zweistufigen Mikrostrukturen**
Process to fabricate a Tool Insert for Injection Moulding a two-level microstructured Piece
Procéde de fabrication d'un moule pour le coulage par injection d'une pièce microstructurée à deux niveaux

(43) Veröffentlichungstag der Anmeldung: 26.05.2004
(73) Patentinhaber: Weidmann Plastics Technology AG, 8640 Rapperswil (CH)
(72) Erfinder: Gmür, Max, 9607 Mosnang (CH)
(74) Vertreter: Ventocilla, Abraham

(56) Entgegenhaltungen:
- US-A1- 2002 098 611
- US-B1- 6 242 163
- OLSSON A ET AL: "Valve-less diffuser micropumps fabricated using thermoplastic replication" MICRO ELECTRO MECHANICAL SYSTEMS, 1997. MEMS ' 97, PROCEEDINGS, IEEE., TENTH ANNUAL INTERNATIONAL WORKSHOP ON NAGOYA, JAPAN 26-30 JAN. 1997, NEW YORK, NY, USA,IEEE, US, 26. Januar 1997 (1997-01-26), Seiten 305-310, XP010216923 ISBN: 0-7803-3744-1

## Beschreibung

Die Erfindung betrifft ein Verfahren zur Herstellung eines mikrostrukturierten Werkzeugeinsatzes zum Spritzgiessen eines Teils, welches aus einem Kunststoff, einem Metall oder aus einem keramischen Material hergestellt wird und welches eine Anordnung von Mikrostrukturen aufweist, die auf einer Aussenfläche des Teils gebildet werden und zwei unterschiedliche, vorbestimmte Tiefen haben.

Harmening et al. (Micro Electro Mechanical Systems 1992, IEEE, Seiten 202-207) offenbart ein Verfahren zur Herstellung von zweistufigen Mikrostrukturen unter Anwendung des LIGA-Verfahrens in Kombination mit der Spritzgusstechnologie sowie Röntgenlithographie.

Die Erfindung betrifft ausserdem ein Verfahren zum Spritzgiessen eines Teils, welches aus einem Kunststoff, einem Metall oder aus einem keramischen Material hergestellt wird und welches eine Anordnung von Mikrostrukturen aufweist, die auf einer Aussenfläche des Kunststoffteils gebildet werden und zwei unterschiedliche, vorbestimmte Tiefen haben, wobei ein Werkzeug zum Spritzgiessen verwendet wird, das von einer ersten und einer zweiten Werkzeughälfte gebildet wird.

US-A-2002/00441053 offenbart ein Verfahren zum Spritzgiessen von Gegenständen aus thermoplastischem Material. Hierzu werden zwei das Spritzgusswerkzeug bildende Werkzeughälften bereitgestellt, wobei in beiden Werkzeughälften mittels Laser Vertiefungen geformt werden, welche die Konturen des zu spritzgiessenden Gegenstandes definieren und in welche das thermoplastische Material für den herzustellenden Gegenstand eingespritzt wird.

Der Artikel 'Valve-Less Diffuser Micropumps Fabricated Using Thermoplastic Replication' von Olsson et al. (Micro electro Mechanical Systems, 1997. MEMS' 97, Proceedings, IEEE., Tenth Annual International Workshop On Nagoya, Japan 26-30 Jan. 1997, New York, NY, USA, IEEE, US, XP010216923 ISBN: 0-7803-3744-1) offenbart ein Verfahren zur Herstellung einer Mikropumpe. Dazu werden mittels Trockenätzen in einem Plasma (DRIE=Deep Reactive Ion Etching) die Strukturen der Mikropumpe in einen Siliziumwafer geätzt. Die geätzte Struktur wird mit Nickel beschichtet und die Nickelbeschichtung als Werkzeugeinsatz in ein Spritzgusswerkzeug zum Spritzgiessen der Mikropumpe mit Polykarbonat eingelegt.

Damit durch Spritzgiessen erzeugte Teile nach dem Spritzgiessen aus dem Werkzeug entformt werden können, ohne dass die Qualität der Mikrostrukturen beeinträchtigt wird, und dass bei grosser Anzahl Mikrostrukturen die Entformungskräfte nicht zu gross werden, müssen die Mikrostrukturen mit Entformungsschrägen versehen werden, welche z. B. grösser als 2 Grad sind, wobei dieser Winkel im Querschnitt zwischen einer Seitenwand der Mikrostruktur und einer zur Aussenfläche des Teils und zur Querschnittsebene senkrechten Ebene gemessen wird.

Die Notwendigkeit, Mikrostrukturen mit Entformungsschrägen erzeugen zu können, welche z.B. grösser als 2 Grad sind, gilt insbesondere bei sehr tiefen Mikrostrukturen, z.B. Mikrostrukturen mit einer Tiefe von 100 Mikrometer oder einer Tiefe die grösser als 100 Mikrometer ist. Für 2-stufigen Mikrostrukturen erfüllt die zweite, tiefere Struktur dieses Kriterium, weshalb Entformungsschrägen für 2-stufige Mikrostrukturen essentiell sind.

Es sind folgende Verfahren bekannt, welche die Herstellung von Teilen mit 2-stufigen Mikrostrukturen ermöglichen:
(A) Nassätzen von Glas
(B) Trockenätzen von Silizium
(C) LIGA
(D) UV-LIGA
(E) Laser Machining
(F) Mikroerosion
(G) Mikrozerspannung (Bohren, Fressen, Drehen)

Aller diese bekannten Mikrostrukturierungsverfahren haben jedoch folgende Nachteile:
Mit dem Verfahren (A) lässt sich nur eine eingeschränkte maximale Strukturtiefe erzielen. Das Verfahren (B) ist schwer beherrschbar. Das Verfahren (C) ist sehr aufwendig und teuer. Mit dem Verfahren (D) lässt sich keine oder nur mit sehr viel Aufwand erzeugte Entformungsschräge erzielen. Die Verfahren (E), (F), (G) sind für eine industrielle Anwendung noch zuwenig entwickelt und sind zudem nur sequentiell durchführbar.

Der Erfindung liegt daher die erste Aufgabe zugrunde ein Verfahren zur Herstellung eines mikrostrukturierten Werkzeugeinsatzes der oben erwähnten Art zur Verfügung zu stellen, das bei 2-stufigen Mikrostrukturen die Erzeugung von Entformungsschrägen mit relativ geringem Aufwand ermöglicht.

Gemäss einem ersten Aspekt der Erfindung wird diese erste Aufgabe mit einem Verfahren gemäss Anspruch 1 gelöst. Bevorzugte Ausführungsformen sind durch Unteransprüche definiert.

Der Erfindung liegt ferner die zweite Aufgabe zugrunde ein Verfahren zum Spritzgiessen eines Teils zur Verfügung zu stellen, das eine Anordnung von Mikrostrukturen aufweist, die auf einer Aussenfläche des Teils gebildet werden, und zwei unterschiedliche, vorbestimmte Tiefen haben und Entformungsschrägen aufweisen, wobei ein Werkzeug zum Spritzgiessen verwendet wird, das von einer ersten und einer zweiten Werkzeughälfte gebildet wird.

Gemäss einem zweiten Aspekt der Erfindung wird diese zweite Aufgabe mit einem Verfahren gemäss Anspruch 6 gelöst.

Die mit den erfindungsgemässen Verfahren erzielten Vorteile sind insbesondere wie folgt:

Das erfindungsgemässe Verfahren ermöglicht auf einfache Weise und mit niedrigen Kosten bei 2-stufigen Mikrostrukturen Entformungsschrägen zu erzeugen, die z.B. grösser als 2 Grad sind. Ein wichtiger Vorteil solcher Entformungsschrägen ist, dass sie die Entformung des Teils ohne Beeinträchtigung der Qualität der 2-stufigen Mikrostrukturen und mit geringen Entformungskräften ermöglichen, auch wenn der Wafer viele Mikrostrukturen aufweist.

Das erfindungsgemässe Verfahren hat den zusätzlichen Vorteil, dass die Ätztiefenunformität der 2-stufigen Mikrostrukturen hervorragend ist, was sonst beim Silizium Trockenätzen insbesondere wenn die Öffnungen unterschiedliche breit sind, nicht der Fall ist.

Die Erfindung wird nachfolgend anhand eines in den beiliegenden Zeichnungen dargestellter Ausführungsbeispiels näher erläutert. In den beiliegenden Zeichnungen zeigen
Fig. 1 die Mikrostrukturierung der Vorderseite eines ersten Wafers mittels Plasmaätzen zur Bildung einer Anordnung von Mikrostrukturen mittels Trenchetching,
Fig. 2 die Mikrostrukturierung der Rückseite des ersten Wafers in Fig. 1 mittels Plasmaätzen zur Bildung einer Anordnung von durch Throughetching erzeugten Hohlräumen,
Fig. 3 das Bonden der Rückseite des ersten Wafers auf ein Trägersubstrat zur Bildung eines Galvano-Masters,
Fig. 4 das elektrochemisches Abscheiden einer Metallschicht auf der Vorderseite des ersten Wafers und in den darin vorhandenen durch die durchgehenden Mikrostrukturen gebildeten Hohlräumen,
Fig. 5 die Verwendung einer vom ersten Wafer und vom damit gebondeten Trägersubstrat abgetrennten Metallschicht als formgebendes Teil eines erfindungsgemäss hergestellten Werkzeugeinsatzes, der in eine Werkzeughälfte eingebaut ist, die zu einem Werkzeug zum Spritzgiessen eines Teils gehört. Fig. 5 zeigt ausserdem eine in den Innenraum des Spritzgusswerkzeugeseingespritzte Kunststoffschmelze.
Fig. 6 die Entformung eines Teils von der soeben erwähnten Metallschicht,
Fig. 7 das aus dem Werkzeug zum Spritzgiessen ausgestossenen Teil.

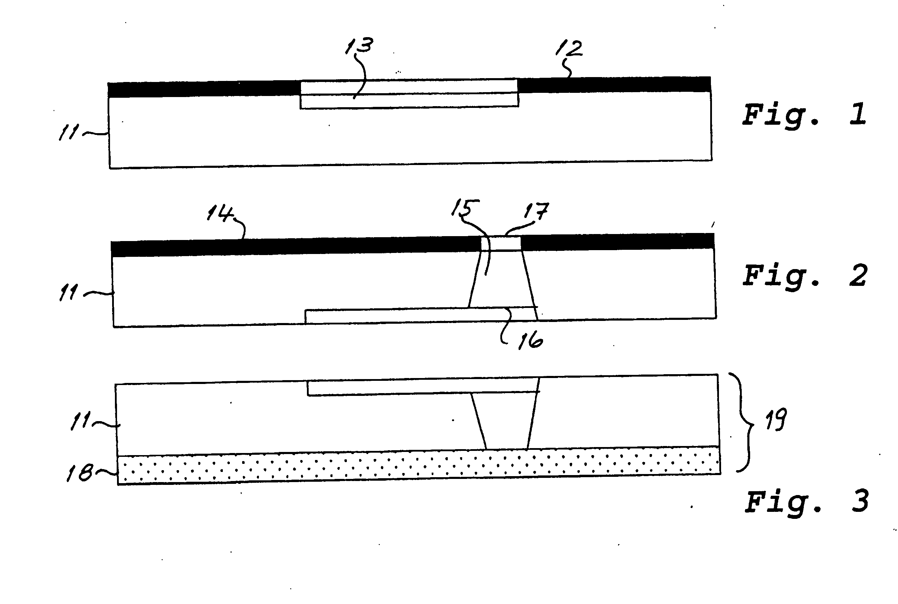

Anhand der Figuren 1 bis 4 wird nachstehend ein Verfahren zur Herstellung eines mikrostrukturierten Werkzeugeinsatzes zum Spritzgiessen eines Kunststoffsteils beschrieben, das eine Anordnung von Mikrostrukturen aufweist, die auf einer Aussenfläche des Kunststoffteils gebildet werden und zwei unterschiedliche vorbestimmte Tiefen haben. Dieses Verfahren ist auch zum Spritzgiessen eines Teils anwendbar, welches aus einem Metall oder aus einem keramischen Material hergestellt wird.

Wie in Fig. 1 gezeigt, wird die Vorderseite eines Silizium-Wafers 11 photolithografisch mit einer Ätzmaskierung 12 maskiert und anschliessend mittels Trockenatzen in einem Plasma (Fachbegriff: DRIE= Deep Reactive Ion Etching) bestehend aus Ionen und reaktiven Fluor Radikalen bis zur gewünschter Tiefe strukturiert (nachfolgend Trenchetching genannt), wobei die Fluor Radikale das Silizium abtragen.

Mittels Trenchetching wird auf diese Weise eine Anordnung von Mikrokanälen 13 auf der Vorderseite des Silizium-Wafers 11 erzeugt. Die Mikrokanäle 13 haben z.B. eine Tiefe von 50 Mikrometer. Der Silizium-Wafer 11 hat z.B. eine Dicke von 250 Mikrometer.

Wie in Fig. 2 gezeigt, wird anschliessend auf der eben mikrostrukturierten Vorderseite des Silizium-Wafers 11 die Atzmaskierung 12 entfernt, der Wafer 11 gewendet, auf der Rückseite des Silizium-Wafers 11 erneut photolithografisch mit einer Ätzmaskierung 14 maskiert und anschliessend mittels Trockenatzen nach der oben beschriebenen Methode strukturiert, wobei dieses Mal die Strukturen durch den Wafer 11 hindurch getrieben werden (nachfolgend Throughetching genannt) und so eine Anordnung von Hohlräumen 15 erzeugt, welche je eine Öffnung 16 auf der Vorderseite des Wafers 11 und eine Öffnung 17 auf der Rückseite des Wafers 11 haben.

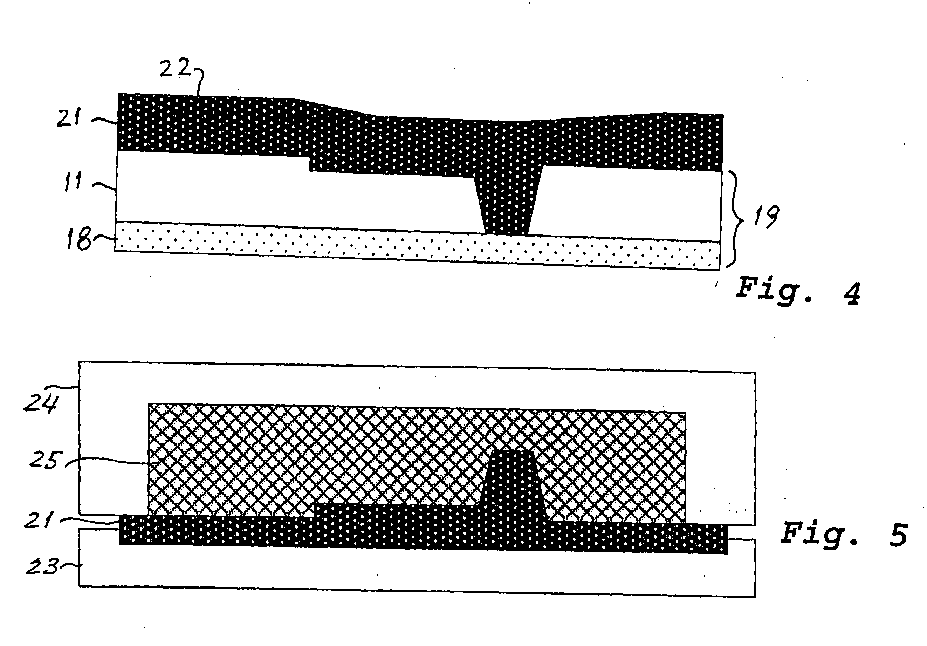

Danach wird die Ätzmaskierung 14 entfernt und der nun fertig strukturierte Wafer 11, wie in Fig. 3 gezeigt, auf ein Trägersubstrat 18 gebondet um die Eigenstabilität zu erhöhen und die Rückseite des Wafers 11 für das elektrochemische auftragen von Nickel zu versiegeln. Durch dieses Bonden vom Wafer 11 und Trägersubstrat 18 wird ein sogenannter Galvano-Master 19 gebildet.

Als Trägersubstrat 18 eignen sich sowohl Pyrex-Wafer (Glas mit hohem Anteil an Natrium) als auch Silizium-Wafer.

Pyrex-Wafer werden mittels anodisch Bonding mit dem mikrostrukturierten Silizium-Wafer untrennbar verbunden. Beim anodisch Bonding wird eine Hochspannung von z.B. 1000 V an die aufeinander gelegten Silizium und Pyrex-Wafer angelegt. Dabei diffundieren Natrium Ionen vom Pyrex in das Silizium und erzeugen eine hochfeste ionische Verbindung zwischen Pyrex und Silizium. Die Diffusion wird zusätzlich beschleunigt durch Erhöhung der Wafertemperatur auf z.B. 400°C).

Silizium-Wafer werden mittels Silicon Fusion Bonding mit dem mikrostrukturierten Silizium-Wafer untrennbar verbunden. Beim Silizium Fusion Bonding werden die zu verbindenden Oberflachen von Silizium Substrat und mikrostrukturiertem Silizium-Wafer konditioniert und anschliessend unter Druck und Temperatur miteinander kovalent verbunden, vorausgesetzt die beiden zu verbindenden Oberflachen weisen sehr geringe Rauhigkeit auf(kleiner als 0.5 Nanometer), damit die beiden Oberflachen unmittelbar miteinander in Kontakt treten.

Als nächster Verfahrensschritt wird das mikrostrukturierte Silizium-Wafer 11 mit dem Trägersubstrat 18, zusammen Master 19 genannt, mit einer leitenden Dünnschicht versehen, die als Startschicht für die nachstehend beschriebene elektrochemische Abscheidung dient. Als solche eignen sich z.B. Gold, Silber und Nickel die physikalisch mittels dem Sputter- (auch bekannt unter dem Begriff Kathodenzerstäubung) oder Aufdampfverfahren nach Beschichtung mit einer Haftschicht aus Aluminium, Titan oder Chrom aufgebracht werden.

Anschliessend wird, wie in Fig. 4. gezeigt, der Master 19 via die leitende Startschicht elektrisch kontaktiert und elektrochemisch eine dicke Metallschicht 21, vorzugsweise eine Nickelschicht abgeschieden, um eine mechanisch stabile Backplatte mit einer Dicke von z.B. 1 Millimeter zu bilden. Nach der oben erwähnten Abscheidung von z.B. einer Nickelschicht 21, auch Nickel Schim genannt, wird zuerst die Ruckseite 22 des Nickel Shims 21 planarisiert. Dazu eignet sich erodieren und schleifen. Anschliessend muss der mikrostrukturierte Nickel Werkzeugeinsatz 21 (nachfolgend Shim genannt) vom Master 19 getrennt werden. Dazu wird der Master 19 entweder mechanisch vom Shim 21 getrennt oder in einer geeigneten Nassätzchemie oder durch Trockenätzen aufgelost.

Die abgetrennten Metallschicht 21 ist als formgebende Teil eines erfindungsgemäss hergestellten Werkzeugeinsatzes verwendbar, und hat seitliche Aussenflächen 26, 27 welche die Bildung von Entformungsschrägen ermöglichen, die z.B. grösser als 2 Grad sind.

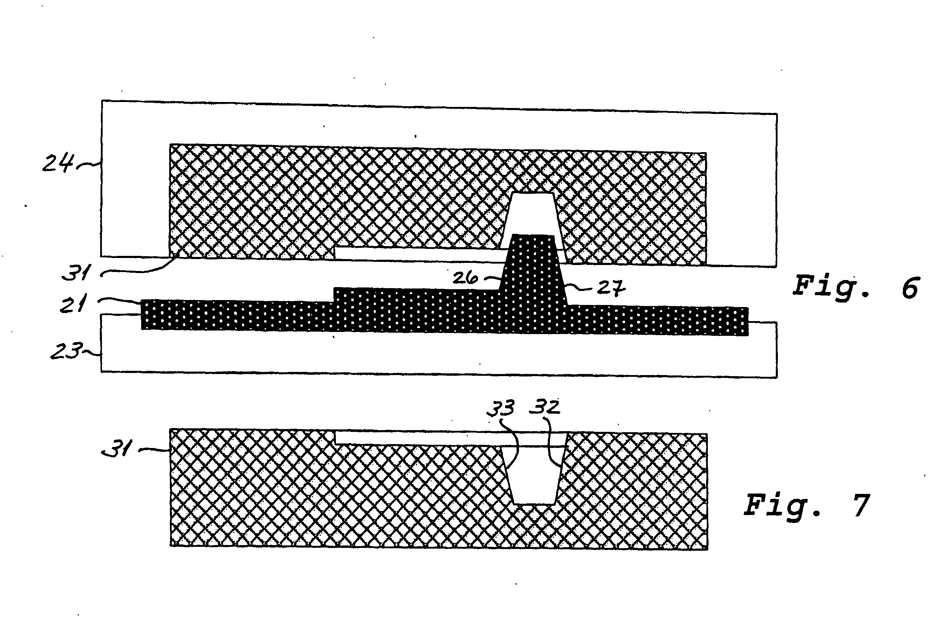

Ein Verfahren zum Spritzgiessen eines Kunststoffsteils wird nachstehend anhand der Figuren 5 bis 7 beschrieben.

Zum Spritzgiessen eines Kunststoffsteils wird der Nickel Shim 21 in einer Werkzeughälfte 23 eingebaut, die gegenüber einer zweiten Werkzeughälfte 24 des Spritzgusswerkzeuges angeordnet ist. Das Spritzgusswerkzeug wird geschlossen und eine Kunststoffschmelze 25 in den Innenraum des Spritzgusswerkzeuges eingespritzt.

Nach dem Erstarren der Kunststoffschmelze 25 und Öffnen des Spritzgusswerkzeuges lässt sich das Kunststoffteil 31 mit wenig Kraftaufwendung vom Shim entformen. Vorteilhaft ist es, dass dabei keine Beeinträchtigung der Qualität der 2-stufigen Mikrostrukturen vorkommt und dass auch wenn der Wafer viele Mikrostrukturen aufweist nur geringe Entformungskräfte erforderlich sind, um das Kunststoffteil zu entformen. Ein weiterer Vorteil des oben beschriebenen Verfahrens ist, dass sich dadurch 2-stufige Mikrostrukturen mit sehr guter Tiefenuniformität herstellen lassen.

Das Kunststoffteil 31 hat Mikrostrukturen mit seitlichen Innenflächen 32, 33 die Entformungsschrägen aufweisen, welche z.B. grösser als 2 Grad sind.

## Patentansprüche

1. Verfahren zur Herstellung eines mikrostrukturierten Werkzeugeinsatzes (21) zum Spritzgiessen eines Teils (31), welches aus einem Kunststoff, einem Metall oder aus einem keramischen Material hergestellt wird und welches eine Anordnung von Mikrostrukturen aufweist, die auf einer Aussenfläche des Teils (31)gebildet werden und zwei unterschiedliche, vorbestimmte Tiefen haben, welches Verfahren folgende Schritte umfasst
(a) photolithographisches Maskieren der Vorderseite eines ersten Wafers (11) mit einer ersten Atzmaskierung (12), welche einer Anordnung von ersten Mikrostrukturen (13) entspricht,
(b) Mikrostrukturieren der Vorderseite des ersten Wafers (11) mittels Plasmaätzen zur Bildung einer Anordnung von ersten Mikrostrukturen (13), welche auf der Vorderseite des Wafers (11) gebildet werden und die eine erste vorbestimmte Tiefe haben,
(c) Entfernen der ersten Ätzmaskierung (12)von der Vorderseite des ersten Wafers (11),
(d) photolithographisches Maskieren der Rückseite des ersten Wafers (11) mit einer zweiten Ätzmaskierung (14), welche einer Anordnung von zweiten Mikrostrukturen (15) entspricht, die mit den ersten Mikrostrukturen (13) auf der Vorderseite des ersten Wafers (11) in fluidische Verbindung stehen sollen,
(e) Mikrostrukturieren der Rückseite des ersten Wafers (11) mittels Plasmaätzen zur Bildung einer Anordnung von zweiten Mikrostrukturen, welche Hohlräume (15) bilden, die auf der Rückseite des ersten Wafers (11) eine erste Öffnung (17) haben und in die ersten Mikrostrukturen (13) auf der Vorderseite des ersten Wafers (11) münden oder auf der Vorderseite des ersten Wafers (11) eine zweite Öffnung haben, wobei das Mikrostrukturieren der Rückseite des ersten Wafers (11) mittels Throughetching des ersten Wafers (11) mit Hinterschnitt durchgeführt wird, so dass die gebildeten Mikrostrukturen einen Querschnitt haben, dessen Breite mit dem Abstand zur Rückseite des ersten Wafers (11) zunimmt, so dass die Mikrostrukturen (15) die Herstellung eines mikrostrukturierten Werkzeugeinsatzes (21) ermöglichen, welcher das Spritzgiessen von Teilen (31) mit Mikrostrukturen ermöglicht, welche Entformungsschrägen (32, 33) grösser als 2 Grad aufweisen.
(f) Entfernen der zweiten Ätzmaskierung (14) von der Rückseite des ersten Wafers (11).
(g) Bonden der Rückseite des ersten Wafers (11) auf ein Trägersubstrat (18) zur Bildung eines Masters (19),
(h) Aufbringen einer elektrisch leitenden Dünnschicht auf der mikrostrukturierten Vorderseite des ersten Wafers (11) und auf den durch die erwähnten Hohlräume (15) zugänglichen Flächen des Trägersubstrats (18),
(i) elektrochemisches Abscheiden einer Metallschicht (21) auf der Vorderseite des ersten Wafers (11) und in den darin vorhandenen durch die zweiten Mikrostrukturen gebildeten Hohlräume (15),
(j) Planarisieren der Aussenfläche der abgeschiedene Metallschicht (21), und
(k) Trennen der Metallschicht (21) vom Master (19), wobei die abgetrennte Metallschicht (21) als Werkzeugeinsatz (21) zum Spritzgiessen eines Teils (31) verwendbar ist.

2. Verfahren gemäss Anspruch 1, **dadurch gekennzeichnet, dass** der erste Wafer (11) ein Silizium-Wafer ist.

3. Verfahren gemäss Anspruch 1, **dadurch gekennzeichnet, dass** das Trägersubstrat (18) ein Pyrex-Wafer ist.

4. Verfahren gemäss Anspruch 1, **dadurch gekennzeichnet, dass** das Trägersubstrat (18) ein Silizium-Wafer ist.

5. Verfahren gemäss Anspruch 1, **dadurch gekennzeichnet, dass** die abgeschiedene Metallschicht (21) eine Nickelschicht ist.

6. Verfahren zum Spritzgiessen eines Teils (31), welches aus einem Kunststoff, einem Metall oder aus einem keramischen Material hergestellt wird und welches eine Anordnung von Mikrostrukturen aufweist, die auf einer Aussenfläche des Teils (31) gebildet werden und zwei unterschiedliche, vorbestimmte Tiefen haben, wobei ein Werkzeug zum Spritzgiessen verwendet wird, das von einer ersten und einer zweiten Werkzeughälfte (23, 24) gebildet wird, welches Verfahren folgende Schritte umfasst
(a) Herstellung eines ersten Werkzeugeinsatzes (21) nach einem der Verfahren gemäss einem der Ansprüche 1 bis 5,
(b) Einbauen des ersten Werkzeugeinsatzes (21) in eine erste Werkzeughälfte (23), die zur Formung der Anordnung von Mikrostrukturen dient,
(c) Schliessen des von der ersten und zweiten Werkzeughälfte (23, 24) gebildeten Werkzeugs zum Spritzgiessen,
(d) Einspritzen einer Materialschmelze (25) in den Raum zwischen der ersten und der zweiten Werkzeughälfte (23, 24),
(e) Abkühlen der eingespritzten Materialschmelze (25), und
(f) Ausstossen aus dem Werkzeug zum Spritzgiessen von einem Teil (31), das durch Erstarrung der eingespritzten Materialschmelze (25) gebildet wird und das Mikrostrukturen mit Entformungsschrägen (32, 33) aufweist.

## Claims

1. Method for producing a microstructured mould insert (21) for injection moulding a part (31) which is produced from a plastics material, a metal or from a ceramic material and which comprises an arrangement of microstructures which are formed at an external face of the part (31) and have two different, predetermined depths, which method comprises the following steps:
(a) photolithographic masking of the front of a first wafer (11) with a first etching mask (12) which corresponds to an arrangement of first microstructures (13),
(b) microstructuring the front of the first wafer (11) by means of plasma etching to form an arrangement of first microstructures (13) which are formed at the front of the wafer (11) and which have a first predetermined depth,
(c) removing the first etching mask (12) from the front of the first wafer (11),
(d) photolithographic masking of the back of the first wafer (11) with a second etching mask (14) which corresponds to an arrangement of second microstructures (15) which are to communicate in fluid terms with the first microstructures (13) at the front of the first wafer (11),
(e) microstructuring the back of the first wafer (11) by means of plasma etching to form an arrangement of second microstructures which form cavities (15) which have a first opening (17) at the back of the first wafer (11) and lead into the first microstructures (13) at the front of the first wafer (11) or have a second opening at the front of the first wafer (11), wherein the microstructuring of the back of the first wafer (11) is carried out by means of through-etching of the first wafer (11) with an undercut, so that the microstructures which are formed have a cross section whose width increases with the distance from the back of the first wafer (11), so that the microstructures (15) make it possible to produce a microstructured mould insert (21) which enables parts (31) with microstructures having drafts (32, 33) greater than 2 degrees to be injection moulded,
(f) removing the second etching mask (14) from the back of the first wafer (11),
(g) bonding the back of the first wafer (11) to a substrate (18) to form a master (19),
(h) applying an electrically conductive thin layer to the microstructured front of the first wafer (11) and to the faces of the substrate (18) which are accessible through the above-mentioned cavities (15),
(i) electrodepositing a metal layer (21) on the front of the first wafer (11) and in the cavities (15) located therein which are formed by the second microstructures,
(j) planarising the external face of the deposited metal layer (21), and
(k) separating the metal layer (21) from the master (19), wherein the separated metal layer (21) can be used as a mould insert (21) for injection moulding a part (31).

2. Method according to Claim 1, **characterised in that** the first wafer (11) is a silicon wafer.

3. Method according to Claim 1, **characterised in that** the substrate (18) is a Pyrex wafer.

4. Method according to Claim 1, **characterised in that** the substrate (18) is a silicon wafer.

5. Method according to Claim 1, **characterised in that** the deposited metal layer (21) is a nickel layer.

6. Method for injection moulding a part (31) which is produced from a plastics material, a metal or from a ceramic material and which comprises an arrangement of microstructures which are formed at an external face of the part (31) and have two different, predetermined depths, wherein a mould for injection moulding which is formed by a first and a second mould part (23, 24) is used, which method comprises the following steps
(a) producing a first mould insert (21) according to one of the methods according to any one of Claims 1 to 5,
(b) fitting a first mould insert (21) into a first mould part (23) which serves to shape the arrangement of microstructures,
(c) closing the mould for injection moulding formed by the first and the second mould part (23, 24),
(d) injecting a material melt (25) into the space between the first and the second mould part (23, 24),
(e) cooling the injected material melt (25), and
(f) ejecting from the mould for injection moulding a part (31) which is formed through solidification of the injected material melt (25) and which comprises microstructures with drafts (32, 33).

## Revendications

1. Procédé pour la fabrication d'un insert d'outil (21) microstructuré, pour le moulage par injection d'une pièce (31), qui est fabriquée à base d'un plastique, d'un métal ou d'un matériau céramique et qui présente un agencement de microstructures qui sont formées sur une surface extérieure de la pièce (31) et ont deux profondeurs prédéfinies différentes, lequel procédé comprend les étapes suivantes :
(a) masquage photolithographique du côté avant d'une première tranche (11) avec un premier masquage de décapage (12), qui correspond à un agencement de premières microstructures (13),
(b) microstructuration du côté avant de la première tranche (11) au moyen de décapage au plasma pour la formation d'un agencement de premières microstructures (13), qui sont formées sur le côté avant de la tranche (11) et qui ont une première profondeur prédéfinie,
(c) enlèvement du premier masquage de décapage (12) du côté avant de la première tranche (11),
(d) masquage photolithographique du côté arrière de la première tranche (11) avec un second masquage de décapage (14), qui correspond à un agencement de secondes microstructures (15), qui doivent être en liaison fluidique avec les premières microstructures (13) sur le côté avant de la première tranche (11),
(e) microstructuration du côté arrière de la première tranche (11) par décapage au plasma pour la formation d'un agencement de secondes microstructures, qui forment des cavités (15) qui ont une première ouverture (17) sur le côté arrière de la première tranche (11) et débouchent dans les premières microstructures (13) sur le côté avant de la première tranche (11) ou ont une seconde ouverture sur le côté avant de la première tranche (11), la microstructuration du côté arrière de la première tranche (11) étant effectuée par "throughetching" de la première tranche (11) avec contre-dépouille, de sorte que les microstructures formées ont une section dont la largeur augmente avec la distance au côté arrière de la première tranche (11), de sorte que les microstructures (15) permettent la fabrication d'un insert d'outil (21) microstructuré, qui rend possible le moulage par injection de pièces (31) avec des microstructures qui présentent des chanfreins de démoulage (32, 33) supérieurs à 2°,
(f) enlèvement du deuxième masquage de décapage (14) du côté arrière de la première tranche (11),
(g) bonding du côté arrière de la première tranche (11) sur un substrat porteur (10) pour la formation d'un maître (19),
(h) application d'une couche mince électroconductrice sur le côté avant microstructuré de la première tranche (11) et sur les surfaces, accessibles par les cavités (15) mentionnées, du substrat porteur (18),
(i) découpage électrochimique d'une couche de métal (21) sur le côté avant de la première tranche (11) et dans les cavités (15) présentes à l'intérieur et formées par les secondes microstructures,
(j) aplanissement de la surface extérieure de la couche de métal (21) déposée, et
(k) séparation de la couche de métal (21) du maître (19), la couche de métal (21) séparée pouvant être utilisée comme insert d'outil (21) pour le moulage par injection d'une pièce (31).

2. Procédé selon la revendication 1, **caractérisé en ce que** la première tranche (11) est une tranche de silicium.

3. Procédé selon la revendication 1, **caractérisé en ce que** le substrat porteur (18) est une tranche de Pyrex.

4. Procédé selon la revendication 1, **caractérisé en ce que** le substrat porteur (18) est une tranche de silicium.

5. Procédé selon la revendication 1, **caractérisé en ce que** la couche de métal (21) déposée est une couche de nickel.

6. Procédé pour le moulage par injection d'une pièce (31), qui est fabriquée à partir d'un plastique, d'un métal ou d'un matériau céramique et qui présente un agencement de microstructures qui sont formées sur une surface extérieure de la pièce (31) et ont deux profondeurs prédéfinies différentes, un outil étant utilisé pour le moulage par injection, lequel est formé par une première et une seconde moitiés d'outil (23, 24), lequel procédé comprend les étapes suivantes :
(a) fabrication d'un premier insert d'outil (21) selon l'un des procédés selon l'une quelconque des revendications 1 à 5,
(b) montage d'un premier insert d'outil (21) dans une première moitié d'outil (23), qui sert au formage de l'agencement de microstructures,
(c) fermeture de l'outil pour le moulage par injection formé par la première et la seconde moitiés d'outil (23, 24)
(d) injection d'une masse fondue de matériau (25) dans l'espace entre la première et la seconde moitiés d'outil (23, 24),
(e) refroidissement de la masse fondue de matériau (25) injectée, et
(f) expulsion de l'outil pour le moulage par injection d'une pièce (31) qui est formée par solidification de la masse fondue de matériau (25) injectée et qui présente des microstructures avec des chanfreins de démoulage (32, 33).
